# EUROPEAN PATENT APPLICATION

(11) **EP 4 851 649 A1**
(43) Date of publication of application: **09.12.2026**
(21) Application number: 26180174.0
(22) Date of filing: 21.05.2026
(51) Int. Cl.: G01R 31/392, G01R 31/3828, G01R 31/3842

(54) **SECONDARY BATTERY CAPACITY RETENTION RATE ESTIMATION METHOD, STORAGE MEDIUM, SECONDARY BATTERY CAPACITY RETENTION RATE ESTIMATION DEVICE, AND BATTERY SYSTEM**

(30) Priority: 28.05.2025 JP 2025089126
(71) Applicant: Prime Planet Energy & Solutions, Inc., Chuo-ku, Tokyo 103-0022 (JP)
(72) Inventor: MATSUURA, Hitomi, Tokyo,, 103-0022 (JP)
(74) Representative: Kuhnen & Wacker Patent- und Rechtsanwaltsbüro PartG mbB

(57) **Abstract**

An estimation method estimates a capacity retention rate of a secondary battery. The method obtains a first timing and a second timing. The method acquires a full charge capacity based on a voltage value at the first timing, an accumulated current value at the first timing, a voltage value at the second timing, and an accumulated current value at the second timing. The method estimates a capacity retention rate at the second timing based on the acquired full charge capacity and an initial full charge capacity. The first timing and the second timing satisfy at least one of the following conditions: an amount of change of the voltage value within a predetermined time period is less than a predetermined first threshold value; and an absolute value of the current value within the predetermined time period is less than a predetermined second threshold value.

## Description

### BACKGROUND

The present disclosure relates to a secondary battery capacity retention rate estimation method, a storage medium, a secondary battery capacity retention rate estimation device, and a battery system.

PCT International Publication No. WO 2017/085869 discloses a capacity retention rate estimation device for a battery. The capacity retention rate estimation device is furnished with an accumulated current value calculation unit, an open circuit voltage calculation unit, and a capacity retention rate estimation unit. The accumulated current value calculation unit calculates an accumulated value of the currents of a battery over an accumulation period. The open circuit voltage calculation unit calculates an open circuit voltage at a first time point and a second time point. The capacity retention rate of the battery is estimated based on a voltage difference of the open circuit voltages of the battery between the first time point and the second time point and an accumulated current value satisfying predetermined conditions. The predetermined conditions are that the accumulated current value is greater than or equal to a predetermined lower limit value and that the average value of the current of the battery during the accumulation period is greater than or equal to a predetermined value.

It is stated that estimating the capacity retention rate using the accumulated current value that satisfies such conditions can reduce errors of the sensor and calculation errors and increase the estimation accuracy of the capacity retention rate.

### SUMMARY

The present inventor wishes to propose a method for appropriately estimating the capacity retention rate of a secondary battery.

A secondary battery capacity retention rate estimation method disclosed herein is a method of estimating a capacity retention rate of a secondary battery always electrically connected to an external device. The estimation method includes obtaining a first timing and a second timing. The estimation method acquires a full charge capacity of the secondary battery based on a voltage value of the secondary battery at the first timing, an accumulated current value at the first timing, a voltage value of the secondary battery at the second timing, and an accumulated current value at the second timing. The estimation method estimates a capacity retention rate of the secondary battery at the second timing based on the acquired full charge capacity and an initial full charge capacity. The estimation method is executed by a computer. The first timing and the second timing satisfy at least one of the following conditions: an amount of change of the voltage value of the secondary battery within a predetermined time period is less than a predetermined first threshold value; and an absolute value of the current value of the secondary battery within the predetermined time period is less than a predetermined second threshold value. The just-described estimation method is able to estimate the capacity retention rate appropriately.

### BRIEF DESCRIPTION OF THE DRAWINGS

Fig. 1 is a schematic view illustrating a battery system 100.
Fig. 2 is a schematic view illustrating the configuration of an estimation device 50.
Fig. 3 is a flowchart illustrating a process executed by a controller 60.
Fig. 4 is a graph illustrating changes over time of current value I and voltage value V of a secondary battery 10.
Fig. 5 is a graph illustrating the relationship between predetermined time period T0 and estimation accuracy of capacity retention rate A.

### DETAILED DESCRIPTION

Hereinbelow, embodiments of the technology according to the present disclosure will be described with reference to the drawings. It should be noted, however, that the embodiments disclosed herein are, of course, not intended to limit the disclosure. The drawings are depicted schematically and do not necessarily accurately depict actual objects. The features and components that exhibit the same effects are designated by the same reference symbols as appropriate, and the description thereof will not be repeated as appropriate.

### Battery System 100

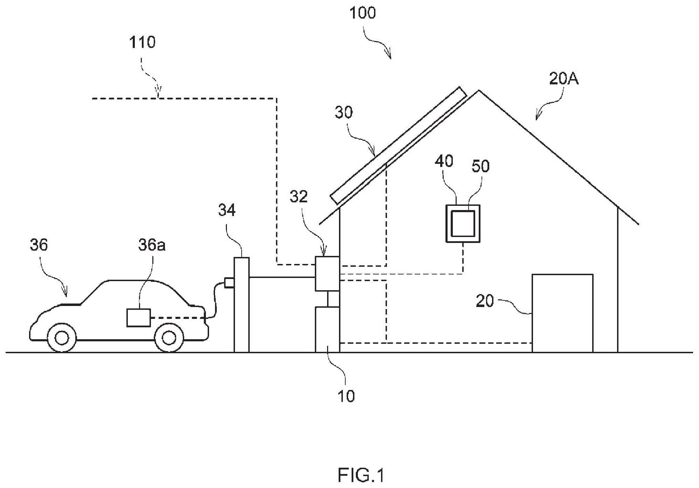

Fig. 1 is a schematic view illustrating a battery system 100. As illustrated in Fig. 1, the battery system 100 includes a secondary battery 10 and an external device 20. The battery system 100 may include an electric vehicle 36 in addition to the external device 20. The battery system 100 includes a power generation device 30, a charge and discharge controller device 40, and an estimation device 50. The battery system 100 is a system for supplying the electric power stored in the secondary battery 10 to the external device 20. The secondary battery 10 is what is called a stationary-type secondary battery. The secondary battery 10 is connected to the external device 20.

In the present description, the term "secondary battery" refers to an electricity storage device capable of releasing electrical energy, which can be repeatedly charged and discharged by means of migration of charge carriers between a pair of electrodes (positive electrode and negative electrode) through an electrolyte. The secondary battery may include lithium-ion secondary batteries, nickel-metal hydride batteries, and lead-acid batteries, for example. How the secondary battery is used is not particularly limited. The secondary battery may be a battery module in which a plurality of secondary batteries (i.e., battery cells) are electrically connected to each other. The stationary-type secondary battery excludes secondary batteries used for electrical devices and appliances that are portable, such as those incorporated as on-board batteries in electrically powered vehicles.

The external device 20, which is the destination of electric power supply, may be a device that is installed in households, offices, factories, commercial facilities, and the like, for example. In this embodiment, the battery system 100 is a system for supplying electric power to a household 20A. The secondary battery 10 is connected to the external device 20, including electrical devices and appliances in the household 20A. The secondary battery 10 and the external device 20 are always electrically connected to each other (except for timings that need to be disconnected unavoidably, such as in case of emergency, maintenance, or the like). In this embodiment, the external device 20 includes an electrical device or appliance that operates 24 hours a day, 365 days a year. The external device 20 also includes such an electrical device or appliance that consumes standby current even when not in use. The external device 20 is always in operation, and electric current always flows through the external device 20. Accordingly, charging or discharging is constantly taking place between the secondary battery 10 and the external device 20. However, because the electric current flows between the secondary battery 10 and the external device 20 corresponds to the operating status of the external device 20, the electric current may sometimes be relatively high, while at other times the current may be very low. Note that the external device 20 excludes such an external device that is connected to the secondary battery 10 only when in use and through which electric current is passed only when in operation (for example, loads of electric vehicles).

The battery system 100 includes a power generation device 30 and a charging and discharging device 32 connected to the secondary battery 10. The charging and discharging device 32 is connected to the external device 20. In this embodiment, the power generation device 30 is a solar power generation device. The power generation device 30 is not limited to the solar power generation device. The power generation device 30 is connected to the secondary battery 10 via the charging and discharging device 32. The charging and discharging device 32 stores the electric power generated by the power generation device 30 in the secondary battery 10. The charging and discharging device 32 may also supply the electric power stored in the secondary battery 10 to the external device 20. The charging and discharging device 32 may also supply the electric power generated by the power generation device 30 directly to the external device 20.

The battery system 100 may also include a charging and discharging station 34 configured to be connectable to the electric vehicle 36. The charging and discharging station 34 is connected to the charging and discharging device 32. The electric power generated by the power generation device 30 and the electric power stored in the secondary battery 10 may be charged into an on-board battery 36a of the electric vehicle 36 via the charging and discharging device 32 and the charging and discharging station 34. The on-board battery 36a of the electric vehicle 36 may supply electric power to the secondary battery 10 via the charging and discharging station 34.

The battery system 100 may be connected to a power utility grid 110 (for example, a commercial power grid). The battery system 100 may interchange electric power with the power utility grid 110 according to the power conditions within the battery system 100. The battery system 100 may receive the supply of electric power from the power utility grid 110 or supply electric power to the power utility grid 110. When the external device 20 or the on-board battery 36a has a shortfall of electric power, the electric power corresponding to the shortfall may be supplied (purchased) from the power utility grid 110 via the charging and discharging device 32. When the external device 20 or the on-board battery 36a has a surplus of electric power, the surplus electric power may be supplied (sold) to the power utility grid 110 via the charging and discharging device 32.

Charging and discharging of the battery system 100 is controlled by the charge and discharge controller device 40. The charge and discharge controller device 40 is a device that controls charging and discharging of the secondary battery 10 contained in the battery system 100. The charge and discharge controller device 40 controls the charging and discharging device 32. The charging and discharging device 40 controls charging to the secondary battery 10 by the power generation device 30, discharging from the secondary battery 10 to the external device 20, and the like. The charge and discharge controller device 40 also controls charging and discharging of the on-board battery 36a of the electric vehicle 36. The charge and discharge controller device 40 also controls charging and discharging between the secondary battery 10 and the power utility grid 110. As described above, the charge and discharge controller device 40 controls charging and discharging within the battery system 100, including the secondary battery 10 and the external device 20.

As the secondary battery 10 is repeatedly charged and discharged, the secondary battery 10 may deteriorate over time. When the secondary battery 10 deteriorates, the electric capacity that can be stored in the secondary battery 10 reduces. In other words, as the secondary battery 10 deteriorates, the capacity retention rate of the secondary battery 10 reduces correspondingly. The capacity retention rate is the current full charge capacity of the secondary battery 10, expressed in percentage, when the initial full charge capacity (before deterioration) is 100%. The capacity retention rate A is calculated according to Equation 1, based on the initial full charge capacity CO and the current full charge capacity C. The capacity retention rate A (%) is in the range of 0 to 100. The full charge capacity is the capacity with 1C constant current discharge at a specific temperature, which is expressed by the product of discharge current and discharge time. The full charge capacity is the electrical capacity when the SOC (State of Charge), which indicates the charging level, is 100%. Note that the deterioration state of the secondary battery 10 may be expressed by SOH (State of Health). $A = \left(C/C0\right) \times 100$ Eq. 1

When the full charge capacity of the secondary battery 10 reduces, it is necessary to control the electric power within the battery system 100, such as charging and discharging to and from the external device 20, based on the reduced full charge capacity. In other words, the electric power within the battery system 100 needs to be controlled taking into consideration the full charge capacity of the secondary battery 10. The charge and discharge controller device 40 is communicably connected to the estimation device 50, which estimates the capacity retention rate of the secondary battery 10. In this embodiment, the estimation device 50 is part of the charge and discharge controller device 40. The estimation device 50 and the charge and discharge controller device 40 may be separate devices from each other.

Hereinafter, a method for estimating the capacity retention rate of the secondary battery 10, which is executed by the estimation device 50, is described along with the configuration of the estimation device 50. The estimation method described in the following may be executed by a computer.

### Estimation Device 50

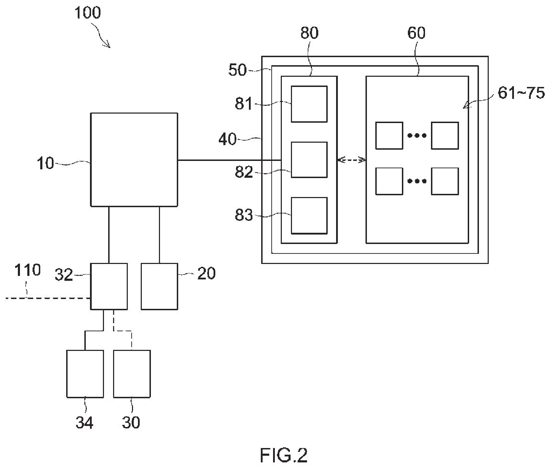

The estimation device 50 includes a controller 60. The controller 60 includes an acquirer 61, a memory storage 62, a first calculator 63, a second calculator 64, a first determiner 65, a second determiner 66, a third determiner 67, a fourth determiner 68, a first time setter 69, a fifth determiner 70, a sixth determiner 71, a full charge capacity acquirer 72, an estimator 73, a second time setter 74, and a corrector 75 (see Fig. 2). The controller 60 may be a computer, such as an ECU (electronic control unit) or a circuit board with a built-in microcomputer, for example. The computer performs required functions according to, for example, a predetermined program. Various functions of the computer may be processed by cooperation of software with an arithmetic unit [also referred to as a processor, CPU (central processing unit), or MPU (micro-processing unit)] and a memory storage device (such as a memory and a hard disk) of the computer. In this embodiment, the controller 60 is implemented by an ECU. The various parts 61 to 75 of the controller 60 may be implemented by a single processor or a plurality of processors, or may be incorporated in a circuit.

Fig. 2 is a schematic view illustrating the configuration of the estimation device 50. As illustrated in Fig. 2, the controller 60 of the estimation device 50 is configured to be communicable with a sensor 80. The sensor 80 includes a voltage sensor 81, a current sensor 82, and a temperature sensor 83.

The voltage sensor 81 detects the voltage value of the secondary battery 10. The current sensor 82 detects the current values of the secondary battery 10 during charge and during discharge. The temperature sensor 83 detects the temperature of the secondary battery 10. When the secondary battery 10 is a battery module, the temperature sensor 83 and the voltage sensor 81 may be provided for each of the single cells of the secondary battery 10. The voltage sensor 81, the current sensor 82, and the temperature sensor 83 detect the voltage value, the current value, and the temperature, respectively, of the secondary battery 10 as analog signals. The voltage value, the current value, and the temperature are detected over time from the secondary battery 10. Herein, the voltage sensor 81, the current sensor 82, and the temperature sensor 83 may detect the current value, the voltage value, and the temperature, respectively, at predetermined intervals. The intervals at which the voltage value, the current value, and the temperature are detected are not limited to specific intervals. The detected analog signals are converted into digital signals by an A/D converter, not shown, and transmitted to the controller 60. The voltage value, the current value, and the temperature are acquired by the acquirer 61 and stored in the memory storage 62. The various parameters during charging and discharging of the secondary battery 10 may be stored in association with time instants.

The first calculator 63 accumulates the acquired current values I contained and calculates an accumulated current value ΣI. The calculated accumulated current value ΣI is stored in the memory storage 62. The accumulation of the current value I is started at the time when a later-described condition (the current value I is less than a second threshold value It) is no longer satisfied. The second calculator 64 calculates an SOC. The SOC is calculated from the current voltage value V and the current temperature. The memory storage 62 may store a table for converting a voltage value into the SOC at each temperature, which has been obtained by testing or the like in advance. The SOC may be calculated using the just-mentioned table based on the voltage value and the temperature. The above-described process may be executed at required intervals whether or not the external device 20 is charged and discharged. The intervals at which the voltage value, the current value, and the temperature are acquired and the intervals at which the accumulated current value ΣI and the SOC are calculated are not limited to specific intervals.

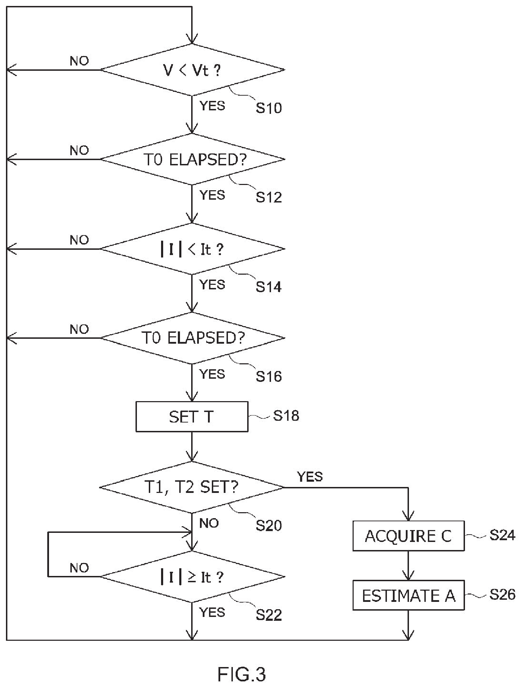

Fig. 3 is a flowchart illustrating a process executed by the controller 60. The controller 60 executes the process based on the acquired parameters (voltage value, current value, and temperature).

At step S10 (see Fig. 3), the first determiner 65 determines whether or not the amount of change of acquired voltage value V is less than a predetermined first threshold value Vt. The first threshold value Vt is a criterion for determining whether or not the voltage value is stable, such as when charging and discharging from the secondary battery 10 to the external device 20 is paused. Note that the amount of change of voltage value V is a change of the voltage value V per unit time, which may be calculated based on the voltage value V acquired over time.

The first threshold value Vt may be determined based on predetermined information corresponding to the characteristics or the like of the secondary battery 10. In this embodiment, the first threshold value Vt is determined based on the temperature and SOC of the secondary battery 10. Table 1 shows an example of the relationship between the first threshold value Vt, SOC, and temperature. The first threshold value Vt is determined generally so as to be higher when the SOC and temperature are higher and to be lower when the SOC and temperature are lower, except when the SOC and the temperature are low (SOC of less than or equal to 40%, lower than or equal to 0°C). It should be noted that the relationship between the first threshold value Vt, SOC, and temperature may vary depending on the characteristics of the secondary battery 10 and is therefore not limited to such an embodiment. The first threshold value Vt may be determined through testing or the like using a test secondary battery that has similar characteristics to those of the secondary battery 10. If the voltage value V is higher than or equal to the first threshold value Vt (NO), the acquisition of the voltage value V and the current value I and so forth are continued.

**TABLE 1**

| First threshold value (ΔmV/min) | | SOC (%) | | | |
|---|---|---|---|---|---|
| | | 80 | 60 | 40 | 20 |
| Temperature (°C) | 45 | 10 | 4 | 2 | 6 |
| | 25 | 8 | 3 | 0.5 | 1 |
| | 0 | 3 | 0.5 | 0.3 | 1 |
| | -20 | 1 | 0.5 | 1 | 0.5 |

When the first threshold value Vt is determined based on at least one of the temperature and the SOC, it is possible to detect stability of the voltage value V more appropriately even when the condition of the secondary battery 10 varies. When the first threshold value Vt is determined based on both the temperature and the SOC, it is possible to detect stability of the voltage value V further more appropriately. Note that the first threshold value Vt may not be determined based on the temperature and SOC. Thus, the first threshold value Vt may be determined based on predetermined information that is acquired from the secondary battery 10. This allows stability of the voltage value V to be detected appropriately. It should be noted that the predetermined information may be determined as appropriate depending on the battery characteristics or the like. If the voltage value V is less than the first threshold value Vt (YES), the process proceeds to step S12.

At step S12 (see Fig. 3), the second determiner 66 determines whether or not the condition in which the acquired voltage value V is less than the first threshold value Vt has continued for a predetermined time period T0. For the "predetermined time period", it is possible to determine a length of time that is sufficient to determine whether or not the voltage value V is stable. The "predetermined time period" may be determined according to the characteristics of the secondary battery 10, the charging and discharging status of the external device 20, and the like. The "predetermined time period" may be set to any time period in the range from 1 minute to 60 minutes, for example, from 5 minutes to 20 minutes, although not limited thereto. If the voltage value V is higher than or equal to the first threshold value Vt or if the condition in which the voltage value V is less than the first threshold value Vt has not continued for the predetermined time period T0 (NO), the process returns to step S10 and continues the determination of whether or not the voltage value V is less than the first threshold value Vt. If the condition in which the voltage value V is less than the first threshold value Vt has continued for the predetermined time period T0 (YES), the process proceeds to step S14.

At step S14 (see Fig. 3), the third determiner 67 determines whether or not the absolute value of acquired current value I is less than a predetermined second threshold value It. The second threshold value It is a criterion for determining whether or not the exchange of electric power between the secondary battery 10 and the external device 20 is minimum, such as when charging and discharging from the secondary battery 10 to the external device 20 are suspended. The second threshold value It may be determined according to the characteristics of the secondary battery 10, the operating status of the external device 20, and the like. When charging and discharging of the external device 20 are suspended, the current value I is ideally 0 A. However, even when charging and discharging are suspended, the current value I may not be 0 A in some cases due to dark current, measurement errors of the current sensor 82, or the like. In this embodiment, the second threshold value It is set to 0.5 A in terms of absolute value. Note that the second threshold value It may be determined as appropriate according to the scale or the like of the external device 20. If the current value I is higher than or equal to the second threshold value It (NO), the process returns to step S10 and continues the acquisition of the voltage value V and the current value I and so forth. If the current value I is less than the second threshold value It (YES), the process proceeds to step S16.

At step S16 (see Fig. 3), the fourth determiner 68 determines whether or not the condition in which the absolute value of the acquired current value is less than the second threshold value It has continued for a predetermined time period T0. The predetermined time period T0 in step S16 may be set to the same length of time period as that in step S12. Such an embodiment is merely exemplary, and step S12 and step S16 may set different lengths of time. If the absolute value of the current value I is higher than or equal to the second threshold value It or if the condition in which the absolute value of the current value I is less than the second threshold value It has not continued for the predetermined time period T0 (NO), the process returns to step S14 and continues the determination of whether or not the current value I is less than the second threshold value It. If the condition in which the current value I is less than the second threshold value It has continued for the predetermined time period T0 (YES), the process proceeds to step S18.

At step S18 (see Fig. 3), the first time setter 69 sets a timing T. Herein, the first time setter 69 sets a first timing T1. This yields the first timing T1. The first timing T1 is selected from among timings that satisfy at least one of the following conditions: the voltage value V within the predetermined time period T0 is less than the first threshold value Vt; and the current value I within the predetermined time period T0 is less than the second threshold value It. In this embodiment, the first timing T1 is set to a time when the voltage value V within the predetermined time period T0 is less than the first threshold value Vt and also the current value I within the predetermined time period T0 is less than the second threshold value It. Herein, the determination at steps S10 and S12 is YES, so the condition that "the voltage value V within the predetermined time period T0 is less than the first threshold value Vt" is satisfied. In addition, the determination at steps S14 and S16 is YES, so the condition that "the current value I within the predetermined time period T0 is less than the second threshold value It" is satisfied. The memory storage 62 stores the voltage value V1 at the first timing T1 and the accumulated current value ΣI1 at the first timing T1.

At step S20, the fifth determiner 70 determines whether or not the first timing T1 and a second timing T2 have been set. If the first timing T1 and the second timing T2 have not been set (NO), the process proceeds to step S22.

At step S22 (see Fig. 3), the sixth determiner 71 determines whether or not the current value I is higher than or equal to the second threshold value It. Here, between the first timing T1 and the second timing T2, it is determined whether or not the absolute value of the current value I is greater than or equal to the second threshold value It. This detects the start of charging and discharging of the secondary battery 10 after the first timing T1. If the current value I is not higher than or equal to the second threshold value It (NO), the process continues the determination. If the current value I is higher than or equal to the second threshold value It (YES), the process returns to step S10 and resumes the foregoing determination. Note that the fifth determiner 70 may determine that the determination is YES if the time during which the current value I is higher than or equal to the second threshold value It continues for a predetermined time period. This eliminates erroneous detection of the current value I by the sensor 80 and allows the start of charging and discharging of the secondary battery 10 to be detected appropriately.

Next, the above-described process subsequent to step S10 is resumed. The description about steps S10 to S18 will not be repeated. However, if the first timing T1 has already been set, the first time setter 69 sets a second timing T2 at step S18. This yields the second timing T2. The criteria for determining second timing T2 may be the same as those for determining the first timing T1. The memory storage 62 stores the voltage value V2 at the second timing T2 and the accumulated current value ΣI2 at the second timing T2. When the second timing T2 is set, the capacity retention rate of the secondary battery 10 is estimated.

As described previously, at step S20, the fifth determiner 70 determines whether or not the first timing T1 and a second timing T2 have been set. If the first timing T1 and the second timing T2 have been set (YES), the process proceeds to step S24.

At step S24 (see Fig. 3), the full charge capacity acquirer 72 acquires a full charge capacity C. The full charge capacity C may be calculated from the comparison between an accumulated current value ΣI and SOC change ΔSOC before and after the accumulation. The full charge capacity C may be calculated according to, for example, the following Equation 2. $C = ΣI / ΔSOC$ Eq. 2

Herein, the full charge capacity C at the second timing T2 is calculated from the accumulated current value ΣI during a period between the first timing T1 and the second timing T2 and the SOC change ΔSOC during a period between the first timing T1 and the second timing T2. The accumulated current value ΣI and ΔSOC may be calculated according to the following Equation 3 and Equation 4. Note that, as described previously, SOC1 and SOC2 can be calculated respectively based on the voltage value V1 and the voltage value V2. The accumulated current value ΣI may be acquired by accumulating the current values I that have been detected during the time from the first timing T1 to the second timing T2. $ΣI = ΣI 2 - ΣΙ 1$ Eq. 3 $ΔSOC = SOC 2 - SOC 1$ Eq. 4

As indicated by Equations 2 to 4 above, the full charge capacity C is calculated based on the voltage value V1 and the accumulated current value ΣI1 at the first timing T1 and the voltage value V2 and the accumulated current value ΣI2 at the second timing T2. This yields the full charge capacity C.

At step S26 (see Fig. 3), the estimator 73 estimates a capacity retention rate A at the second timing T2. The capacity retention rate A is estimated from the full charge capacity C at the second timing T2 and the initial full charge capacity C0. The capacity retention rate A is calculated based on the foregoing Equation 1. When the capacity retention rate A is estimated, the process returns to step S10 and continues the above-described process. The capacity retention rate A is constantly estimated and updated according to charging and discharging of the secondary battery 10. Hereinafter, the processing of the estimation device 50 will be described along with an example of the charging and discharging status of the secondary battery 10.

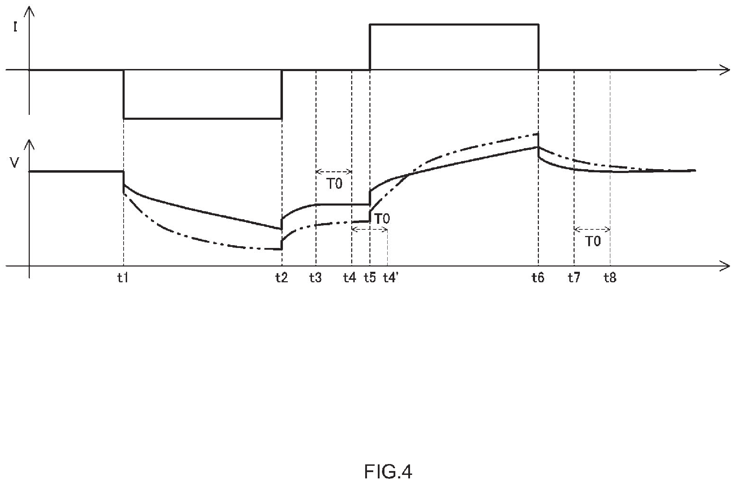

Fig. 4 is a graph illustrating changes over time of current value I and voltage value V of the secondary battery 10. In Fig. 4, the voltage value for the secondary battery immediately after manufacture (a secondary battery that has not yet been deteriorated) is indicated by the solid line, and the voltage value for the secondary battery that has deteriorated is indicated by the dash-dot-dot line. Herein, the external device 20 that is connected to the secondary battery 10 is constantly in operation. The current value I flowing through the secondary battery 10 and the voltage value V applied to the secondary battery 10 change over time.

In the embodiment shown in Fig. 4, at time point t1, the external device 20 starts to be used. The secondary battery 10 (secondary battery immediately after manufacture) starts to be discharged to the external device 20 at a substantially constant current value I. Electric power may be supplied form the secondary battery 10 to the external device 20. At this time, the absolute value of the current value I is higher than or equal to the second threshold value It. The voltage value V lowers instantaneously. Thereafter, the voltage value V lowers, but the amount of change of the voltage value V gradually decreases.

At time point t2, the use of the external device 20 ends. Discharging of the secondary battery 10 is suspended. Although the discharging is suspended, the external device 20 is in operation. At this time, the absolute value of the current value I is approximately 0 A, which is less than the second threshold value It. The voltage value V rises instantaneously. Thereafter, the voltage value V rises, but the amount of change of the voltage value V gradually decreases.

At time point t3, the amount of change of the voltage value V becomes less than the first threshold value Vt. At time point t2 onward, the absolute value of the current value I remains less than the second threshold value It. At this time, the determination is YES in steps S10 to S16. At step S18, time point t4 is set as the first timing T1. At time point t4, at which the predetermined time period T0 has elapsed since time point t3, the voltage value V1 and the accumulated current value ΣI1 of the secondary battery 10 are acquired.

At time point t5, the secondary battery 10 starts to be charged at substantially a constant current value. Here, the electric power consumed from time point t1 to time point t2 is charged. Electric power may be supplied form the power generation device 30 to the secondary battery 10. At this time, the absolute value of the current value I is higher than or equal to the second threshold value It. At step S22, the process determines YES and returns to step S 10. The voltage value V rises instantaneously. Thereafter, the voltage value V rises, but the amount of change of the voltage value V gradually decreases.

At time point t6, the secondary battery 10 becomes fully charged, and charging to the secondary battery 10 is suspended. Note that although the charging is suspended, the external device 20 is in operation. At this time, the absolute value of the current value I is approximately 0 A, which is less than the second threshold value It. The voltage value V lowers instantaneously. Thereafter, the voltage value V lowers, but the amount of change of the voltage value V gradually decreases.

At time point t7, the amount of change of the voltage value V becomes less than the first threshold value Vt. At time point t6 onward, the absolute value of the current value I remains less than the second threshold value It. At this time, the determination is YES in steps S10 to S16 after the first timing T1 has been set. At step S18, the second timing T2 is set. At time point t8, at which the predetermined time period T0 has elapsed since time point t7, the voltage value V2 and the accumulated current value ΣI2 of the secondary battery 10 are acquired. The full charge capacity C is obtained based on the voltage values V1 and V2 and the accumulated current values ΣI1 and ΣI2 (step S22). Thereafter, the capacity retention rate A is estimated from the full charge capacity C and the initial full charge capacity CO (step S24).

In a secondary battery or the like that is connected to an electrical device that is started up upon use and shut down after use, the status of the secondary battery is stable at the timings of starting up and shutting down. For this reason, it is likely that the capacity retention rate is estimated stably when the capacity retention rate is estimated at the time of starting up and shutting down. On the other hand, in the case of a stationary-type secondary battery, the secondary battery is connected to the external device at all times. For this reason, for the stationary-type secondary battery, it is difficult to identify the timing at which the status of the secondary battery is stable, so the estimation accuracy of the capacity retention rate may become lower.

In the above-described embodiment, the estimation method is a method of estimating the capacity retention rate of a secondary battery 10 that is always electrically connected to an external device 20. The estimation method obtains a first timing T1 and a second timing T2 (step S18). The estimation method acquires a full charge capacity C of the secondary battery 10 based on a voltage value V1 of the secondary battery 10 at the first timing T1, an accumulated current value ΣI1 at the first timing T1, a voltage value V2 of the secondary battery 10 at the second timing T2, and an accumulated current value ΣI2 at the second timing T2 (step S24). The estimation method estimates a capacity retention rate A of the secondary battery 10 at the second timing T2 based on the acquired full charge capacity C and an initial full charge capacity CO (step S26). The estimation method is executed by a computer. The first timing T1 and the second timing T2 satisfy at least one of the following conditions: an amount of change of a voltage value V of the secondary battery 10 within a predetermined time period T0 is less than a predetermined first threshold value Vt; and an absolute value of a current value I of the secondary battery 10 within the predetermined time period T0 is less than a predetermined second threshold value It. Such an estimation method estimates the capacity retention rate A based on the information of the secondary battery 10 that is acquired before and after the timing at which at least one of the voltage value V and the current value I is stable. As a result, the estimation accuracy of the capacity retention rate A is improved.

In the above-described embodiment, the first timing T1 and the second timing T2 are a time when the amount of change of the voltage value V of the secondary battery 10 within the predetermined time period T0 is less than the predetermined first threshold value Vt and also the absolute value of the current value I of the secondary battery 10 within the predetermined time period T0 is less than the predetermined second threshold value It. When estimating the capacity retention rate A, the voltage value V and the current value I are stable, so it is more likely to improve the estimation accuracy of the capacity retention rate A based on the voltage value V and the current value I. Moreover, in this case, the capacity retention rate A is not estimated at, for example, such timing before the voltage value becomes stable immediately after charging and discharging are suspended, or such timing in which charging and discharging are performed with a very low current and the variation of the voltage value is small. Because the capacity retention rate A is not estimated at such timing, the estimation accuracy of the capacity retention rate A is more likely to improve.

In the above-described embodiment, during a period between the first timing T1 and the second timing T2, the absolute value of the current value I of the secondary battery 10 is greater than or equal to the predetermined second threshold value It. The secondary battery 10 is charged and discharged during a period between the first timing T1 and the second timing T2, the accumulated current value ΣI and ΔSOC tend to be greater. As a result, the estimation accuracy of the capacity retention rate A is likely to improve easily.

In the above-described embodiment, the first timing T1 and the second timing T2 are set at step S18. As described previously, at the second timing T2, the capacity retention rate A is estimated based on the voltage value V and the current value I at the first timing T1 and the second timing T2. The second timing T2 for estimating the capacity retention rate A this time may serve as the first timing T1 when estimating the capacity retention rate A next time. When appropriate, the timing at which the capacity retention rate A is measured this time (i.e., the timing at which the current capacity retention rate A is measured) may also be called the second timing T2, while the timing at which the capacity retention rate A was measured last time may also be called the first timing T1. In the case where charging and discharging of the secondary battery 10 are repeated in the battery system 100 as well, the first timing T1 and the second timing T2 are set one after another, so that the capacity retention rate A is estimated repeatedly.

In the above-described embodiment, the capacity retention rate A is estimated based on the information (the voltage value V and the current value I herein) at the first timing T1 and the second timing T2. However, such embodiments are merely illustrative. The capacity retention rate A may be estimated based on information before the first timing T1 and the second timing T2.

The controller 60 may also include a corrector 75 that weighs an estimated capacity retention rate A1 of the secondary battery 10 and a last estimated capacity retention rate AO of the secondary battery 10 to correct the estimated capacity retention rate A of the secondary battery 10. This allows the capacity retention rate A to be corrected based on the capacity retention rates that have been estimated at different timings (the capacity retention rates A0 and A1 herein). As a result, the estimation accuracy of the capacity retention rate A may improve. The corrector 75 may correct the capacity retention rate according to, for example, the following Equation 5. Such weighting of the capacity retention rates A0 and A1 may be carried out at step S24. Note that a value greater than 0 and less than 1 may be selected for the parameter α. $A = A 1 \times α + A 0 \times \left(1-α\right)$ Eq. 5

When the predetermined time period T0 is set to be longer, the time for determining whether or not the voltage value V and the current value I are stable is accordingly longer. This may increase the accuracy of detecting the stability of the voltage value V and the current value I. However, when the predetermined time period T0 is set longer, the voltage value V and the current value I need to be stable continuously for a longer time, so the frequency of detecting the voltage value V and the current value I may decrease.

In Fig. 4, the secondary battery immediately after manufacture and the deteriorated secondary battery show the same current value I. As shown in Fig. 4, even when the charge-discharge current is the same, the deteriorated secondary battery (indicated by the dash-dot-dot line) shows a greater variation (amount of change) of the voltage value V than the secondary battery immediately after manufacture (indicated by the solid line). Therefore, the deteriorated secondary battery requires a longer time until the voltage value V stabilizes. In the embodiment shown in Fig. 4, the voltage value V of the deteriorated secondary battery has reached the first threshold value Vt at time point t4. Thereafter, at time point t4', at which the predetermined time period T0 has elapsed, the voltage value V and the current value I exceed the first threshold value Vt and the second threshold value It, respectively. Therefore, the first timing T1 is not set, and the capacity retention rate A is not estimated. In addition, at time point t8, at which it is detected that the voltage value V of the secondary battery 10 immediately after manufacture has stabilized, the voltage value V of the deteriorated secondary battery remains higher than the first threshold value Vt. The deteriorated secondary battery requires a longer time to stabilize the voltage value V.

It is possible that the predetermined time period T0 may be set as appropriate. The controller 60 may also include a second time setter 74 that can set the predetermined time period T0. The second time setter 74 may set the predetermined time period T0 in response to the input from an administrator of the secondary battery 10, such as the user. The second time setter 74 may set the predetermined time period T0 automatically. The second time setter 74 may set the predetermined time period T0 according to the deterioration status (for example, the capacity retention rate A) of the secondary battery 10. The second time setter 74 may set the predetermined time period T0 so that the less the capacity retention rate A, the shorter the predetermined time period T0.

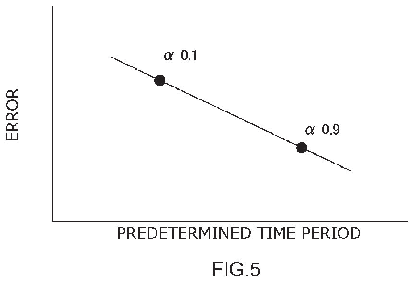

Fig. 5 is a graph illustrating the relationship between predetermined time period T0 and estimation accuracy of capacity retention rate A. As illustrated in Fig. 5, the longer the predetermined time period T0, the less the estimation error of the capacity retention rate A. This means that when the predetermined time period T0 is longer, the estimation accuracy of the capacity retention rate A may be higher, while the predetermined time period T0 is shorter, the estimation accuracy of the capacity retention rate A may be lower. The corrector 75 may weigh the estimated capacity retention rate A1 of the secondary battery 10 and the last estimated capacity retention rate AO of the secondary battery 10 according to the length of the predetermined time period T0. When the predetermined time period T0 is longer, the accuracy of the capacity retention rate A that has been estimated this time may be higher. Therefore, the parameter α in Equation 5 may be set to be greater. By estimating the capacity retention rate A based on the predetermined time period T0, which is relevant to the estimation accuracy, the estimation accuracy of the capacity retention rate A may be improved. Even when the secondary battery has deteriorated, setting the predetermined time period T0 to be shorter allows the estimation frequency of the capacity retention rate A to be maintained and also allows the estimation accuracy to be unlikely to reduce.

The above-described estimation method may be performed by the estimation device 50. The estimation device 50 includes a non-transitory computer-readable storage medium that stores a computer program for executing the above-described estimation method, and one or more processors capable of executing the computer program stored in the storage medium.

Various embodiments of the technology according to the present disclosure have been described hereinabove. Unless specifically stated otherwise, the embodiments described herein do not limit the scope of the present disclosure. It should be noted that various other modifications and alterations may be possible in the embodiments of the technology disclosed herein. In addition, the features, structures, or steps described herein may be omitted as appropriate, or may be combined in any suitable combinations, unless specifically stated otherwise. In addition, the present description includes the disclosure as set forth in the following items.

### Item 1:

A method, executed by a computer, of estimating a capacity retention rate of a secondary battery always electrically connected to an external device, including:
obtaining a first timing and a second timing;
acquiring a full charge capacity of the secondary battery based on a voltage value of the secondary battery at the first timing, an accumulated current value at the first timing, a voltage value of the secondary battery at the second timing, and an accumulated current value at the second timing; and
estimating a capacity retention rate of the secondary battery at the second timing based on the acquired full charge capacity and an initial full charge capacity, wherein:
   the first timing and the second timing are selected from among timings satisfying at least one of the following conditions:
   an amount of change of a voltage value of the secondary battery within a predetermined time period is less than a predetermined first threshold value; and
   an absolute value of a current value of the secondary battery within the predetermined time period is less than a predetermined second threshold value.

### Item 2:

The method according to item 1, wherein the first timing and the second timing is a time when the amount of change of the voltage value of the secondary battery within the predetermined time period is less than the predetermined first threshold value and the absolute value of the current value of the secondary battery within the predetermined time period is less than the predetermined second threshold value.

### Item 3:

The method according to item 1 or 2, wherein at least one of the first threshold value, the second threshold value, and the predetermined time period is determined based on predetermined information acquired from the secondary battery.

### Item 4:

The method according to item 3, wherein the predetermined information includes at least one of a temperature of the secondary battery and a state of charge (SOC) of the secondary battery.

### Item 5:

The method according to item 4, wherein the first threshold value is predetermined according to the temperature of the secondary battery and the SOC of the secondary battery.

### Item 6:

The method according to any one of items 1 through 5, wherein the absolute value of the current value of the secondary battery is greater than or equal to the predetermined second threshold value during a period between the first timing and the second timing.

### Item 7:

The method according to any one of items 1 through 6, wherein an estimated capacity retention rate of the secondary battery and a last estimated capacity retention rate of the secondary battery are weighted to correct the estimated capacity retention rate of the secondary battery.

### Item 8:

The method according to item 7, wherein the estimated capacity retention rate of the secondary battery and the last estimated capacity retention rate of the secondary battery are weighted according to a length of the predetermined time period.

### Item 9:

A non-transitory computer-readable storage medium storing a program causing a computer to execute the method according to any one of items 1 through 8.

### Item 10:

A device for estimating a capacity retention rate of a secondary battery, including:
a non-transitory computer-readable storage medium storing a program causing a computer to execute the method according to any one of items 1 through 8; and
one or more processors capable of executing the computer program stored in the storage medium.

### Item 11:

A battery system including:
an external device;
a secondary battery connected to the external device; and
the device according to item 10.

## Claims

1. A method, executed by a computer, of estimating a capacity retention rate (A) of a secondary battery (10) always electrically connected to an external device (20), comprising:
obtaining a first timing (T1) and a second timing (T2);
acquiring a full charge capacity (C) of the secondary battery (10) based on a voltage value (V1) of the secondary battery (10) at the first timing (T1), an accumulated current value (ΣI1) at the first timing (T1), a voltage value (V2) of the secondary battery (10) at the second timing (T2), and an accumulated current value (ΣI2) at the second timing (T2); and
estimating a capacity retention rate (A) of the secondary battery (10) at the second timing (T2) based on the acquired full charge capacity (C) and an initial full charge capacity (C0), wherein:
the first timing (T1) and the second timing (T2) are selected from among timings satisfying at least one of the following conditions:
an amount of change of a voltage value (V) of the secondary battery (10) within a predetermined time period (T0) is less than a predetermined first threshold value (Vt); and
an absolute value of a current value (I) of the secondary battery (10) within the predetermined time period (T0) is less than a predetermined second threshold value (It).

2. The method according to claim 1, wherein the first timing (T1) and the second timing (T2) is a time when the amount of change of the voltage value (V) of the secondary battery (10) within the predetermined time period (T0) is less than the predetermined first threshold value (Vt) and the absolute value of the current value (I) of the secondary battery (10) within the predetermined time period (T0) is less than the predetermined second threshold value (It).

3. The method according to claim 1 or 2, wherein at least one of the first threshold value (Vt), the second threshold value (It), and the predetermined time period (T0) is determined based on predetermined information acquired from the secondary battery (10).

4. The method according to claim 3, wherein the predetermined information includes at least one of a temperature of the secondary battery (10) and a state of charge (SOC) of the secondary battery (10).

5. The method according to claim 4, wherein the first threshold value (Vt) is predetermined according to the temperature of the secondary battery (10) and the SOC of the secondary battery (10).

6. The method according to claim 1 or 2, wherein the absolute value of the current value (I) of the secondary battery (10) is greater than or equal to the predetermined second threshold value (It) during a period between the first timing (T1) and the second timing (T2).

7. The method according to claim 1 or 2, wherein an estimated capacity retention rate (A) of the secondary battery (10) and a last estimated capacity retention rate (A0) of the secondary battery (10) are weighted to correct the estimated capacity retention rate (A) of the secondary battery (10).

8. The method according to claim 6, wherein the estimated capacity retention rate (A) of the secondary battery (10) and the last estimated capacity retention rate (AO) of the secondary battery (10) are weighted according to a length of the predetermined time period (T0).

9. A non-transitory computer-readable storage medium storing a program causing a computer to execute the method according to claim 1 or 2.

10. A device for estimating a capacity retention rate (A) of a secondary battery (10), comprising:
a non-transitory computer-readable storage medium storing a program causing a computer to execute the method according to claim 1 or 2; and
one or more processors capable of executing the computer program stored in the storage medium.

11. A battery system comprising:
an external device (20);
a secondary battery (10) connected to the external device (20); and
the device according to claim 10.
